# EUROPEAN PATENT APPLICATION

(11) **EP 4 287 510 A1**
(43) Date of publication of application: **06.12.2023**
(21) Application number: 22176893.0
(22) Date of filing: 02.06.2022
(51) Int. Cl.: H03K 17/082, H03K 17/687

(54) **OVERCURRENT PROTECTION CIRCUIT FOR FAST SWITCHING SEMICONDUCTORS, AND METHOD OF PROTECTING FAST SWITCHING SEMICONDUCTORS FROM OVERCURRENTS**

(71) Applicant: Airbus S.A.S., 31060 Toulouse (FR)
(72) Inventor: KAPAUN, Florian, 82024 Taufkirchen (DE); STEINER; Gerhard, 82024 Taufkirchen (DE)
(74) Representative: OTN Airbus SAS

(57) **Abstract**

An overcurrent protection circuit (10) and a protection method for fast switching semiconductors comprises a semiconductor switch unit (11) comprising one or more semiconductor switches (12, 13), a resistor element (14) which generates a voltage signal depending on a current through the semiconductor switch unit (11), an amplification unit (15) which amplifies the voltage signal, a comparator unit (16) which compares the amplified voltage signal with a threshold value, and which generates a disable signal when the amount of the amplified voltage signal is greater than the threshold value. A switching device (17) is switching off the semiconductor switch unit (11) when the switching device (17) receives the disable signal.

## Description

The invention relates to an overcurrent protection circuit for fast switching semiconductors, and to a method of protecting fast switching semiconductors from overcurrents.

In particular, the invention is applicable to power electronics switches and modules.

State of the art semiconductor protection circuits normally use a so called desaturation (DESAT) detection to prevent e.g. IGBTs from over-/short currents. In case of overcurrents, the IGBT desaturates which leads to collector-emitter voltage increase, which can be detected, and current limitation by the device. As the current stops increasing, the desaturation detection and switching off of the device can be relatively slow, e.g. up to some microseconds without destroying the semiconductor. Typical driver integrated circuits (driver ICs) with desat detection can switch off the device within some microseconds. To detect the desat event securely, the voltage level is quite high, typically in the range of 7 Volts.

New technologies like Wide Band Gap (WBG) semiconductors, like e.g SiC and GaN semiconductors, do not show such kind of desaturation at reasonable values, so the current is not actively limited by the device. In addition the on-state resistance (RDSon) is very low. So the voltage drop even in case of high currents or overcurrents is far below the threshold of 7V. Even for ICs with lower threshold, an adequate safe turn off for such WBG semiconductor technologies is not possible.

Further, DESAT detection is within some microseconds. Within that time span, the semiconductor must be switched off to avoid a damage of the semiconductor. But this is not the case for newer semiconductors like e.g. white WBG semiconductors because they do not really saturate, that means internally nothing limits the current. In a silicon carbide semiconductor for example, the current is increasing more and more until it is damaged.

A further problem is the temperature dependence of DESAT detection. It can be adjusted to a certain value, however the threshold significantly changes with the temperature. Also the current level for a dedicated voltage across the semiconductor changes with temperature. Further, absolute tolerances occur which modify the current level.

It is the object of the invention to solve the still existing problems of non sufficient overcurrent protection for fast switching semiconductors, like e.g. WBG semiconductors, that do not show sufficient current saturation behaviour when switching to a short circuit.

According to a first aspect, the invention provides an overcurrent protection circuit for fast switching semiconductors, comprising a semiconductor switch unit comprising one or more semiconductor switches; a resistor element for generating a voltage signal depending on a current through the semiconductor switch unit; an amplification unit configured for amplifying the voltage signal; a comparator unit configured to compare the amplified voltage signal with a threshold value, and to generate a disable signal when the amount of the amplified voltage signal is greater than the amount of the threshold value; and a switching device configured for switching off the semiconductor switch unit when the switching device receives the disable signal.

The expression "amount of" shall be understood in the way that the signs of the respective values, whether positive or negative, shall not be considered, but only the amounts. It may also be expressed as "absolute value of".

The reason is that the amplified voltage signal may be a positive or a negative voltage signal, depending on the direction of the current flow. Also a positive or a negative threshold value may be selected.

Preferably, the overcurrent protection circuit comprises a filter unit connected to the resistor element and configured to filter out interfering components from the voltage signal before supplying it to the comparator unit.

Preferably, the overcurrent protection circuit comprises a blank filter unit connected between the comparator unit and the switching device, for blocking the disable signal for a predefined blank time before supplying it to the switching device.

Preferably, the resistor element is configured as a shunt resistor, which is in particular provided external to the semiconductor switch unit.

Preferably, the semiconductor switch unit comprises two semiconductor switches connected in anti-series to each other.

Preferably, the semiconductor switch unit comprises one or more Wide Band Gap power semiconductors.

Preferably, the overcurrent protection circuit comprises a driver integrated circuit controlled by the switching device, to switch off the semiconductor switch unit when the switching device receives the disable signal.

Preferably, the overcurrent protection circuit comprises a voltage source connected to the comparator unit, for providing a freely selectable voltage defining the threshold value to the comparator unit.

According to a second aspect, the invention provides a method of protecting fast switching semiconductors from overcurrents, comprising the steps:
generating a voltage signal via a resistor element, depending on a current through a semiconductor switch unit; amplifying the voltage signal,
comparing the amplified voltage signal with a threshold value; generating a disable signal when the amount of the amplified voltage signal is greater than the amount of the threshold value; switching off the semiconductor switch unit when the disable signal is received by a switching device configured for switching-off the semiconductor switch unit.

Preferably, interfering components are filtered out from the voltage signal before it is supplied to the comparator unit.

Preferably, the method comprises blocking the disable signal for a predefined blank time before supplying the disable signal to the switching device.

Preferably, the blanking time is set to less than 1200 ns, more preferably less than 600 ns, still more preferably in particular less than 300 ns, in particular equal to or less than 150 ns.

Preferably, an external shunt resistor is used as the resistor element.

Preferably, the amount of the amplified voltage signal is selected within the range of 1 to 1000 mV, more preferably 50 to 500 mV, most preferably 75 to 150 mV. It may be positive or negative.

Preferably, a voltage is freely selected to define the threshold value. It may be a positive or a negative voltage.

Preferably, the overcurrent protection circuit according to the invention, as it is described herein, is used in the protection method.

By the overcurrent detection circuit and by the method according to the invention, the electric current is detected as fast and as accurately as possible in order to be able to generate a fast switch off e.g. in case of a failure.

The invention provides a circuit that is able to detect and switch off overcurrents at semiconductors within some hundreds of nanoseconds, and therefore is able to protect even the fastest semiconductors on the market. This invention is crucial for the safety of each power module. It can be attached to any power module or power semiconductor.

In particular, the invention provides a circuit and a method that allows to protect even very fast switching semiconductors from overcurrents. A fast switching WBG power semiconductor (e.g. SiC) therefore will not be destroyed any more, even when it switches on a short circuit or other situation where the current is not limited any more by an external circuit.

For overcurrent detection, the usage of an external shunt resistor is proposed, as it is more temperature stable than the internal on-state resistance RDSon of the semiconductor. If no external shunt is desired, the internal RDSon can also be used.

To detect the overcurrent as fast as possible, in particular within less than 100 ns, very fast amplifiers and comparators are used. The overcurrent level can be chosen freely. To avoid disturbance due to ringing effects, some filtering or blanking time is preferably provided. Also adapting the overcurrent level is possible.

After detecting the overcurrent, a disable signal may directly be fed into e.g. a gate drive IC (primary e.g. PWM input or enable pin) or secondary side (desat pin if present). As the solution on the primary side is often faster (t<100ns vs.t >300ns), this is more preferred. The latter is also a method that can be used on nearly any gate drive on the market. To avoid differences in ground reference potential, some kind of isolation of PWM Signal may be provided.

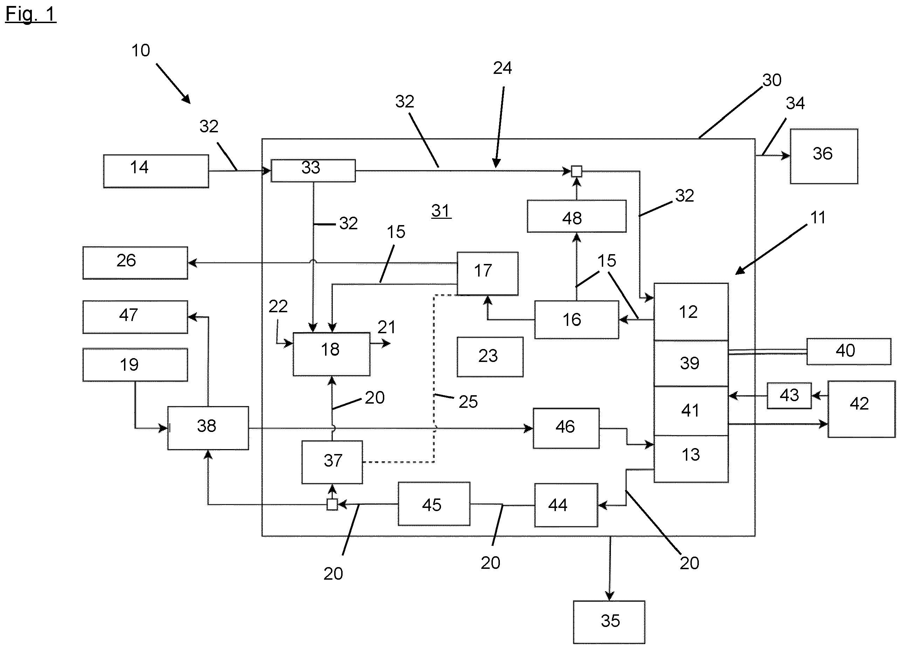

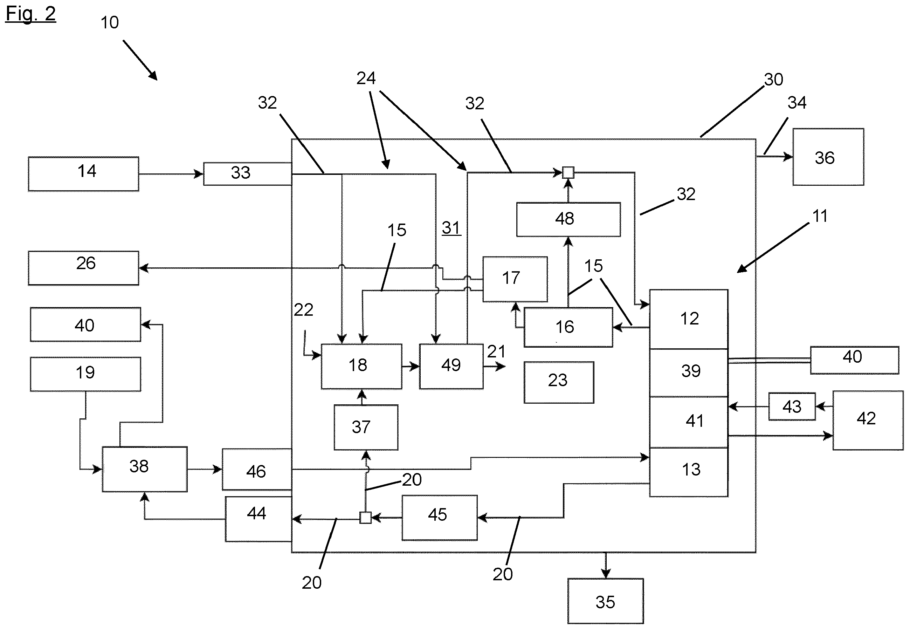

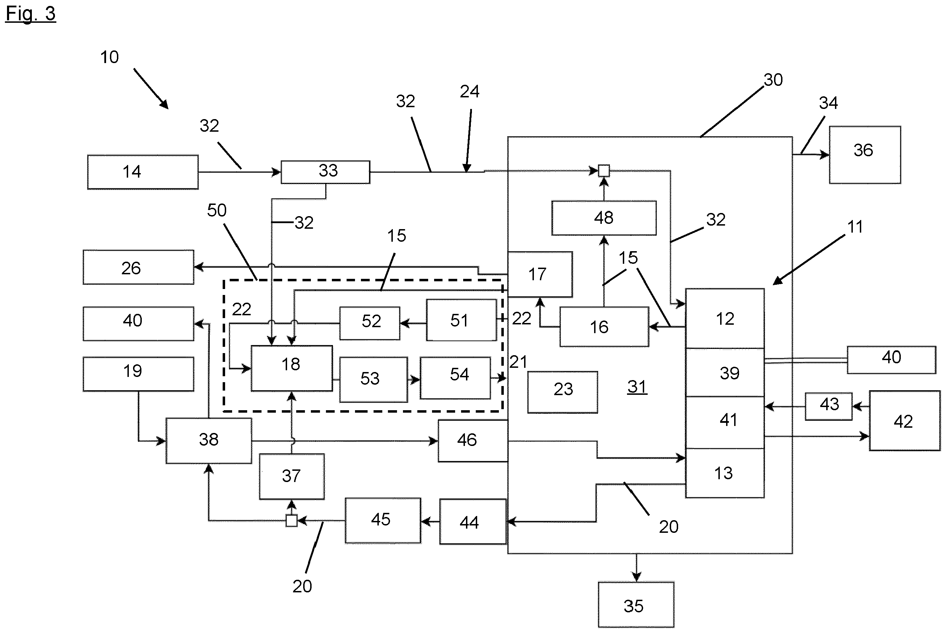

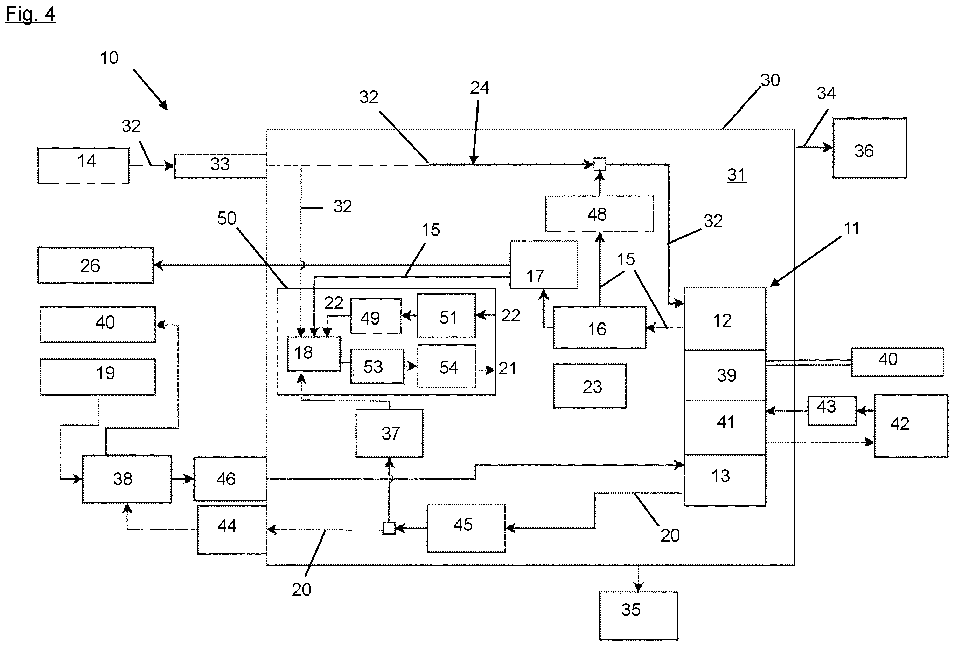

In the following, a preferred exemplary embodiment of the invention showing further advantages and characteristics is described with reference to
- **Fig. 1**: which shows a schematic diagram of an overcurrent detection circuit connected to a voltage source, according to a preferred embodiment of the invention.

**Fig. 1** shows a protection circuit 10 connected to a battery 25 in this example. It comprises a semiconductor switch unit 11 comprising one or more fast switching semiconductors 12, 13, and a resistor element formed by a shunt resistor 14 for generating a voltage signal depending on a current through the semiconductor switch unit 11. Protection circuit 10 further comprises an amplification unit 15 for amplifying the voltage signal, and a comparator unit 16 to compare the amplified voltage signal with a threshold value and to generate a disable signal when the amplified voltage signal is above the threshold value. A transistor 17 forms a switching device for switching off the semiconductor switch unit 11 when the switching device or transistor 17 receives the disable signal generated by the comparator unit 16.

In this example, two semiconductors formed by fast switching semiconductors 12, 13 are connected in anti-series to be able to switch off the current in both directions. The circuit 10 detects the electric current in both current flow directions very fast and with highest accuracy and generates a fast switch off e.g. in case of a failure.

The external shunt resistor 14 is included for measuring the current. It should be as small as possible to avoid great losses also in case of high currents. Here for example it is 100 micro Ohm. It is provided external to the switching unit 11.

A filter unit 18 is connected to the resistor element 14 and configured to filter out interfering components from the voltage signal before supplying it to the comparator unit 16.

Such interfering components may e.g. occur in case of switching edges. Further, the resistance is not ideal resistance which means that additionally parasitic components may occur. Therefore, filter unit 18 is provided to get back the original signal. It performs several functions.

The filter unit or circuit 18 is a compensation unit which neutralises or at least filters out parasitic effects. First, it provides a low pass filter. At the moment of switching the current changes suddenly, and there are voltage peaks across the shunt, because it comprises an inductivity. However, it is not intended to trigger on that, because such voltage change is not necessarily a fault signal, even if the voltage shows a short deflection. The voltage across the inductivity together with the steepness of the current results in a constant value which is the offset. The offset caused by the inductivity is eliminated. Such components are e.g. filtered out. In particular the filter unit 18 compensates stray inductance of the shunt resistor 14. In addition, there is a certain temperature dependence which is compensated by filter unit 18.

The measurement resistance caused by shunt resistor 14 is very low, e.g. 0,1 mOhm, and accordingly the voltage drop is very low, for example about some millivolts. Amplification unit 15 comprises a high speed amplifier circuit. It is provided for amplifying the voltage signal, in order to get an acceptable level for further processing the signal. The amplification may be for example by a factor of 10.

Comparator unit 16 is able to detect an overcurrent in both current flow directions very fast, for example in the range of 100 to 150 ns. Comparator unit 16 comprises a purely analogue circuit which compares the actual value of the amplified signal with a defined maximum value which is a threshold value. The threshold value defines when a specific current is achieved and switch-off of shall take place. Since the current my flow in both directions, the signs of the amplified signal value and of the threshold value, whether positive or negative, can be reversed.

Comparator unit 16 comprises a first input 20 for receiving the amplified signal. A second input 21 of comparator unit 16 is provided for receiving the threshold value or voltage. That threshold can be adjusted freely, i.e. the comparator unit 16 is adjustable. It specifies when the current is too high and switch off shall take place. The threshold voltage is provided by threshold voltage source 22, and may be for example 0,5 V or 3,3V, or it may have any other value including also a negative voltage according to the specific application requirements.

The comparator unit 16 has two states corresponding to whether or not the received amplified voltage signal, regardless of its sign, i.e. considering its amount or absolute value only, is greater than the threshold voltage received from threshold voltage source 22. Also the threshold voltage may be positive or negative, and therefore only the amount or its absolute value is considered. Accordingly, one of two possible output voltage levels are at the output 23 of comparator unit 16. Possible amounts of output voltage levels are for example 0 V / 5 V or 0 V / 3,3 V, depending on how the comparator is fed. It compares both input values very fast and outputs the output value. If the amount of the amplified voltage signal is greater than the amount of the threshold voltage, or its absolute value, the output voltage of comparator unit 16 forms the disable signal.

A blank filter unit 19 is provided for ignoring the disable signal received from comparator unit 16 for a certain period of time, which is called blanking time. Blank filter 19 is connected between the comparator unit 20 and the transistor 17. It blocks the disable signal for the blank time, before supplying it to transistor unit 17. The reason is that when the semiconductors 12, 13 switch, the whole system is quite disturbed, because there are relatively high current and voltage transitions and the system has to settle before.

Filter unit 18 and/or blanking filter 19 provide the time period to avoid disturbances during voltage and current transition

If the current is still too high after the blanking time, which means that at the input 20 of comparator unit 16 is still a voltage which is within the overcurrent range, the disable signal passes blanking filter 19 to transistor 17, which is switched on by the disable signal or voltage. As a result, driver IC 24 connected to transistor 17 switches off the semiconductor switches 12, 13. The driver IC 24 may be any simple standard driver.

However, switching of semiconductor switches 12, 13 depending on the disable signal or voltage provided by the comparator unit 20 can be realized in other ways than by a driver IC. For example, it may also be realised without driver IC, but with a pure analogue circuit instead, which switches of the semiconductors 12, 13, thus limiting or interrupting the current if it is too high.

An electric isolation 26 separates the potential of the semiconductor switch unit 11 from other components which are at a different potential, like e.g. control electronics.

The circuit 10 allows to freely adjust the threshold value and to compensate disturbing aspects like temperature dependency and other parasitic elements, and it is much faster than the overcurrent protection known hitherto.

In this example, the semiconductor switches 12, 13 are Wide Band Gap (WBG) semiconductors, which are the most critical because they are the fastest and need to be switched of very fast. But the protection circuit 10 is also advantageous when other types of semiconductor switches are used, like e.g. IGBTs, MOSFETs, and others.

As shown in the figure, one side of the protection circuit 10 is connected to a voltage source provided by battery 25. The other side of the protection circuit 10 may e.g. be connected to a load or consumer network which is not shown in the figure.

However, the configuration is not limited thereto. In general, the protection circuit may be connected between any types of electric networks to protect them from damages caused by currents which are too high, i.e. the so-called overcurrents.

In this example, the protection circuit 10 is configured as a common source DC-switch for battery applications. However, despite that, the circuit can be used on any kind of power switch topology, like single switch, half-bridge, full-bridge, etc., with different locations of the shunt, depending on the application and switch topology.

A preferred example of a method of protecting fast switching semiconductors from overcurrents is described in the following. It comprises the steps:
Generating a voltage signal via resistor element 14, depending on a current through semiconductor switch unit 11.

Amplifying the voltage signal by amplification unit 15.

Comparing the amplified voltage signal with a threshold value by comparator unit 20.

Generating a disable signal when the amplified voltage signal is above the threshold value by comparator unit 20.

Switching off the semiconductor switch unit 11 when the disable signal is received by a switching device 17 configured for switching-off the semiconductor switch unit 11.

Interfering components like e.g. described above are filtered out from the voltage signal by filter unit 18, before it is supplied to the comparator unit 20.

The disable signal is blocked for a predefined blank time before supplying the disable signal to the switching device.

The current limit in this example is 500 A. For measuring the current, an external shunt resistor of 0,1 mOhm is used as resistor 14 . It is connected in series to semiconductor switches 12, 13. Thus, the voltage drop across shunt resistor 14 is 50 mV when the current limit is reached. This voltage signal is amplified by a factor of 10, i.e. to 0,5 V and supplied to input 20 of comparator unit 16. Accordingly, the threshold voltage source 22 connected to the input 21 of comparator unit 16 is selected to provide a voltage of 0,5 V. Thus, the disable signal is output from comparator unit 16 when the voltage signal received at its input 20 is above 0,5 V. Because the current may flow in both directions, this is an absolute value or the amount only, i.e. regardless whether positive or negative. Also different trigger levels might be used for positive and negative currents, e.g. by using two comparators, one for positive and the other for negative currents.

When the disable signal is received by blanking filter 19 for a period of more than the appropriate blanking time, which is dependent on the specific components used in protection circuit 10, transistor 17 is activated which causes to switch off the semiconductor switches 12, 13 via driver IC 24.

Particular benefits of the invention are:
- Ultra fast detection of overcurrent
- Switch off affected semiconductors within some hundreds of nanoseconds
- Suitable for the protection of WBG semiconductors
- Increased safety of power devices and complete inverters
- Increased system reliability

### List of reference numbers:

- 10: protection circuit
- 11: semiconductor switch unit
- 12, 13: fast switching semiconductors
- 14: resistor element / shunt resistor
- 15: amplification unit
- 16: comparator unit
- 17: switching device / transistor
- 18: filter unit
- 19: blank filter unit 19
- 20: first input of comparator unit
- 21: second input 21 of comparator unit
- 22: threshold voltage source
- 23: output of comparator unit
- 24: driver IC
- 25: battery
- 26: isolation

## Claims

1. Overcurrent protection circuit for fast switching semiconductors, comprising a semiconductor switch unit (11) comprising one or more semiconductor switches (12, 13),
a resistor element (14) for generating a voltage signal depending on a current through the semiconductor switch unit (11),
an amplification unit (15) configured for amplifying the voltage signal,
a comparator unit (16) configured to compare the amplified voltage signal with a threshold value, and to generate a disable signal when the amount of the amplified voltage signal is greater than the amount of the threshold value, and
a switching device (17) configured for switching off the semiconductor switch unit (11) when the switching device (17) receives the disable signal.

2. Overcurrent protection circuit according to claim 1, **characterized by** a filter unit (18) connected to the resistor element (14) and configured to filter out interfering components from the voltage signal before supplying it to the comparator unit (16).

3. Overcurrent protection circuit according to claim 1 or 2, **characterized by** a blank filter unit (19) connected between the comparator unit (16) and the switching device (17), for blocking the disable signal for a predefined blank time before supplying it to the switching device (17).

4. Overcurrent protection circuit according to one of the preceding claims, **characterized in that** the resistor element (14) is configured as a shunt resistor provided external to the semiconductor switch unit (11).

5. Overcurrent protection circuit according to one of the preceding claims, **characterized in that** two semiconductor switches (12, 13) are connected in anti-series to each other.

6. Overcurrent protection circuit according to one of the preceding claims, **characterized in that** the semiconductor switch unit (11) comprises one or more Wide Band Gap power semiconductors.

7. Overcurrent protection circuit according to one of the preceding claims, **characterized by** a driver integrated circuit controlled by the switching device (17), to switch off the semiconductor switch unit (11) when the switching device (17) receives the disable signal.

8. Overcurrent protection circuit according to one of the preceding claims, **characterized by** a voltage source connected to the comparator unit (16), for providing a freely selectable voltage defining the threshold value to the comparator unit (16).

9. Method of protecting fast switching semiconductors from overcurrents, comprising:
generating a voltage signal via a resistor element (14), depending on a current through a semiconductor switch unit (11),
amplifying the voltage signal,
comparing the amplified voltage signal with a threshold value,
generating a disable signal when the amount of the amplified voltage signal is greater than the amount of the threshold value,
switching off the semiconductor switch unit (11) when the disable signal is received by a switching device (17) configured for switching-off the semiconductor switch unit (11).

10. Method according to claim 9, **characterized in that** interfering components are filtered out from the voltage signal before it is supplied to the comparator unit (16).

11. Method according to claim 9 or 10, **characterized by** blocking the disable signal for a predefined blank time before supplying the disable signal to the switching device (17).

12. Method according to claim 11, **characterized in that** the blanking time is set to
| | |
|---|---|
| 11.1. | less than 1200 ns, or |
| 11.2. | less than 600 ns, or |
| 11.3. | less than 300 ns, or |
| 11.4. | equal or less than 150 ns |

13. Method according to one of claims 9 to 12, **characterized in that** an external shunt resistor is used as the resistor element (14).

14. Method according to one of claims 9 to 13, **characterized in that** the amount of the amplified voltage signal is selected within the range of
| | |
|---|---|
| 14.1. | to 1000 mV, or |
| 14.2. | 50 to 500 mV, or |
| 14.3. | 75 to 150 mV. |

15. Method according to one of claims 9 to 15, **characterized in that** a voltage is freely selected to define the threshold value.
